# EUROPEAN PATENT APPLICATION

(11) **EP 2 365 110 A1**
(43) Date of publication of application: **14.09.2011**
(21) Application number: 11250251.3
(22) Date of filing: 04.03.2011
(51) Int. Cl.: C30B 23/00, C30B 29/36

(54) **Apparatus and method for producing silicon carbide single crystal**

(30) Priority: 04.03.2010 JP 2010047888
(71) Applicant: Bridgestone Corporation, Tokyo 104-8340 (JP)
(72) Inventor: Kondo, Daisuke, Kodaira-shi, Tokyo 187-8531 (JP)
(74) Representative: Oxley, Robin John George

(57) **Abstract**

A crucible includes: a crucible body (5) configured to hold the sublimation raw material a lid (11) configured to close an opening of the crucible body and provided with a mounting portion (9) configured to support the seed crystal; and a guide member (13) extending toward a sublimation raw material side from an outer peripheral portion of the mounting portion. The guide member has a cover portion (27) configured to cover an outer peripheral portion of the seed crystal from the sublimation raw material side, the cover being protruded from a mounting unit side end portion (21) provided on a mounting portion side.

## Description

### CROSS REFERENCE TO RELATED APPLICATIONS

This application is based upon and claims the benefit of priority from prior Japanese Patent Application No.2010-047888, filed on March 4, 2010; the entire contents of which are incorporated herein by reference.

### BACKGROUND OF THE INVENTION

### 1. Field of the Invention

The present invention relates to an apparatus for producing a silicon carbide single crystal, which can prevent the poor quality of a single crystal grown from a bevel portion of a seed crystal, and relates also to a method for producing a silicon carbide single crystal.

### 2. Description of the Related Art

Conventionally, there has been known a sublimation recrystallization method which produces a silicon carbide single crystal from a seed crystal including silicon carbide and a sublimation raw material. A crucible used in the sublimation recrystallization method is provided with a guide member in the form of a cylinder in order to intensively and efficiently supply sublimation gas to a seed crystal (for example, see Japanese Patent Publication No. 2004-224663).

However, there is a problem in the conventional guide member as described above that a single crystal grown from an outer peripheral portion of the seed crystal may be defective. That is, a growth surface of the seed crystal may be planarized by a machining process such as polishing. That is, since the outer peripheral portion of the seed crystal is called a bevel portion and may have a concave-convex portion, particle shedding and the like, a single crystal growing from the bevel portion may have many defective portions.

### SUMMARY OF THE INVENTION

A first aspect is summarized as an apparatus for producing a silicon carbide single crystal, configured to hold a seed crystal (seed crystal) including silicon carbide and a sublimation raw material (sublimation raw material 3) in a crucible (crucible 1) while facing each other, configured to generate sublimation gas (sublimation gas G) by heating the seed crystal and the sublimation raw material, and grow the silicon carbide single crystal on the seed crystal. The crucible includes: a crucible body (crucible body 5) configured to hold the sublimation raw material; a lid (lid 11) configured to close an opening of the crucible body and provided with a mounting portion (mounting portion 9) configured to support the seed crystal; and a guide member (guide member 13) extending toward a sublimation raw material side from an outer peripheral portion of the mounting portion. The guide member has a cover portion (cover portion 27) configured to cover an outer peripheral portion (bevel portion 35) of the seed crystal from the sublimation raw material side, the cover being protruded from a mounting portion side end portion (mounting portion side end portion 21) provided on a mounting portion side.

According to the first aspect, since the guide member is provided with the cover portion which covers the bevel portion formed of the outer peripheral portion of the seed crystal, when a single crystal is grown, it is possible to suppress the growth of the single crystal from the bevel portion formed of the outer peripheral portion of the seed crystal. Since the single crystal grown from the bevel portion includes many defective portions, a good single crystal can be obtained by suppressing the growth of the single crystal from the bevel portion.

In the first aspect, the cover portion may be formed by cutting out an inner peripheral side of the mounting portion side end portion.

A second aspect is summarized as a method for producing a silicon carbide single crystal by holding a seed crystal including silicon carbide and a sublimation raw material in a crucible while facing each other, generating sublimation gas by heating the seed crystal and the sublimation raw material, and growing the silicon carbide single crystal on the seed crystal. The method includes the steps of: (A) heating the sublimation raw material to generate the sublimation gas in a crucible including a crucible body configured to hold the sublimation raw material, a lid provided with a mounting portion configured to close an opening of the crucible body and configured to support the seed crystal, and a guide member extending toward the sublimation raw material from an outer peripheral portion of the mounting portion (raw material heating step S2); and (B) growing the silicon carbide single crystal on the seed crystal in a state where a cover portion covers an outer peripheral portion of the seed crystal from a sublimation raw material side, the cover being protruded from a mounting portion side end portion provided on a mounting portion side (seed crystal growing step S3).

In the second aspect, the method for producing a silicon carbide single crystal, may further include a step of (C) causing H to be smaller than W (raw material/seed crystal disposing step S1), where H denotes a distance in a thickness direction of the seed crystal between a growth surface facing the sublimation raw material in an outer peripheral portion of the seed crystal and a cover surface facing the seed crystal in the cover portion, and W denotes a distance in a diameter direction of the seed crystal between an outer peripheral portion edge of the seed crystal and an inner peripheral end edge in the cover portion.

In the second aspect, the distance H may be 0 mm to 0.5 mm and the distance W may be 0.5 mm to 2 mm.

### BRIEF DESCRIPTION OF THE DRAWINGS

Fig. 1 is a cross-sectional view showing an apparatus for producing a silicon carbide single crystal according to an embodiment of the present invention;
Fig. 2 is a cross-sectional view of a guide member shown in Fig. 1;
Fig. 3 is an enlarged cross-sectional view of a mounting unit side end portion in the guide member shown in Fig. 2;
Fig. 4 is a diagram corresponding to Fig. 3, which shows a conventional example;
Fig. 5 is a cross-sectional view showing the dimension of the mounting unit side end portion in the guide member shown in Fig. 2;
Fig. 6 is an enlarged cross-sectional view of a bevel portion of a seed crystal;
Fig. 7 is a cross-sectional view showing a state where a silicon carbide single crystal is grown using, a conventional production apparatus;
Fig. 8 is a schematic diagram when a growth crystal shown in Fig. 7 is viewed from the lower side thereof;
Fig. 9 is a flowchart showing a method for producing a silicon carbide single crystal according to the present invention;
Fig. 10 is a perspective view of the silicon carbide single crystal grown by production apparatus according to the present invention; and
Fig. 11 is a perspective view of a silicon carbide single crystal grown by a conventional production apparatus.

### DETAILED DESCRIPTION OF THE EMBODIMENTS

Hereinafter, details of an apparatus for producing a silicon carbide single crystal according to embodiments of the present invention will be described with reference to the accompanying drawings. Specifically, the description will be made in the following order: (1) Overall configuration of apparatus for producing silicon carbide single crystal; (2) Detailed configuration of guide member; (3) Description of generation principle of poor quality in growth crystal; (4) Method for producing silicon carbide single crystal; (5) Comparison evaluation; (6) Operation and effect; and (7) Other embodiments of the present invention.

It will be appreciated that the drawings are schematically shown and a thickness and a ratio of the thickness of each material layer are different from a real size. Therefore, detailed thickness and dimension should be determined considering the following description. Of course, in the drawings, the dimensional relationship and the ratio are different.

### (1) Overall configuration of apparatus for producing silicon carbide single crystal

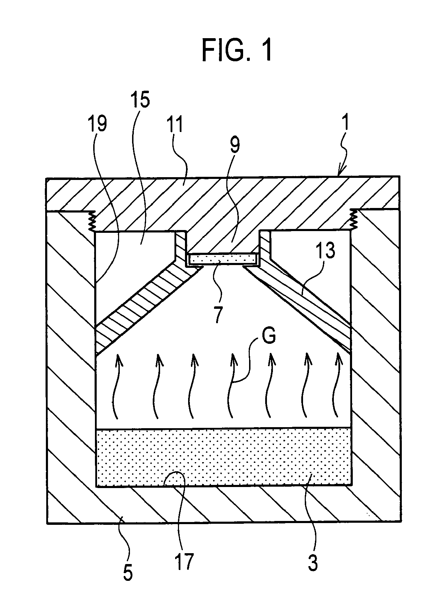

Fig. 1 is a cross-sectional view showing an apparatus for producing a silicon carbide single crystal according to an embodiment of the present invention.

The production apparatus has a crucible 1. The crucible 1 includes a crucible body 5 configured to hold a sublimation raw material 3 therein, a lid 11 provided with a mounting portion 9, which is mounted on the upper end portion of the crucible body 5, configured to fix a seed crystal 7 at a position facing the sublimation raw material 3, and a guide member 13 in the form of a cylinder which obliquely extends downward to the sublimation raw material 3 from the vicinity of the outer periphery of the mounting portion 9. The crucible body 5 and the lid 11 are made of graphite and the seed crystal 7 is made of silicon carbide (SiC).

The crucible body 5 is provided in the form of a cylindrical body formed on the upper end thereof with an opening 15, and holds the powdered sublimation raw material 3 made of silicon carbide at the bottom portion 17. Furthermore, the lid 11 is screwed into the opening 15 on the upper end to be detachably provided to the crucible body 5.

The lid 11 is also provided in the form of a cylinder, and the cylindrical mounting portion 9 protrudes at the center in the radial direction of the lid 11, which faces the sublimation raw material 3, in the downward direction of the sublimation raw material 3 side to fix the seed crystal 7.

In addition, the guide member 13 is formed obliquely downward from the vicinity of an outer peripheral side of the mounting portion 9 in such a way that the guide member 13 has a diameter increasing gradually and an approximately truncated cone shape in a lateral view. The lower end portion of the guide member 13 is locked with an inner wall surface 19 of the crucible body 5, so that the guide member 13 is held. Moreover, if the sublimation raw material 3 and the seed crystal 7 are heated, sublimation gas G is generated from the sublimation raw material 3, and a single crystal is grown from the seed crystal 7.

### (2) Detailed configuration of guide member

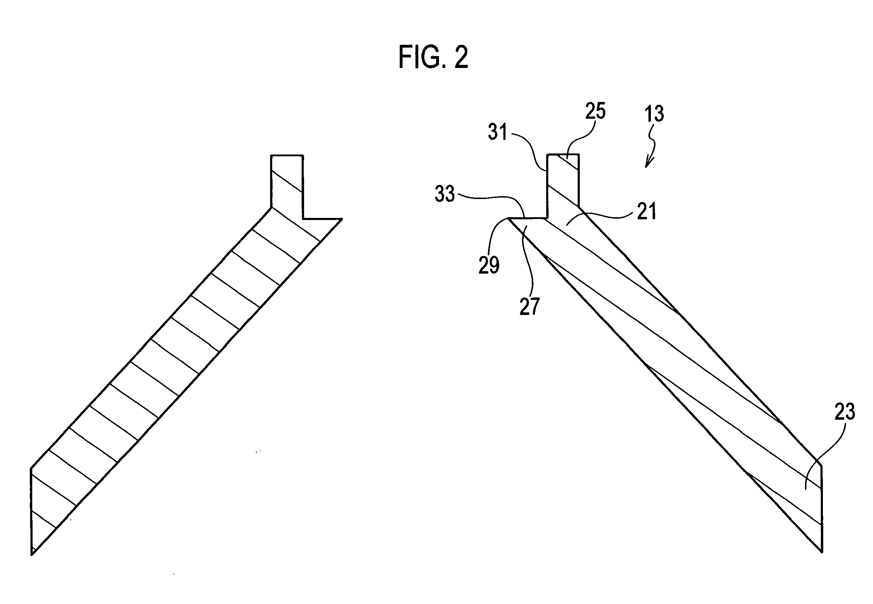

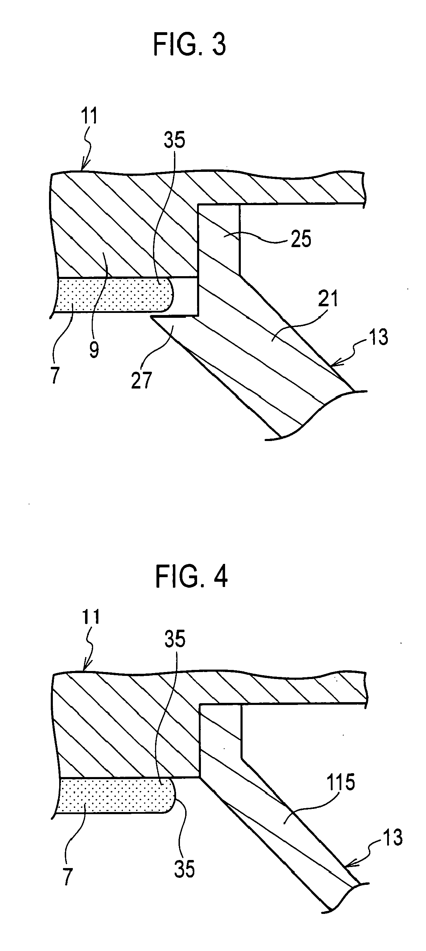

Fig. 2 is a cross-sectional view of the guide member shown in Fig. 1. Fig. 3 is an enlarged cross-sectional view of a mounting unit side end portion in the guide member shown in Fig. 2.

The guide member 13 is a cylindrical member made of graphite and formed in such a way that the guide member 13 has a diameter increasing gradually from the upper end to the lower side thereof and a truncated cone shape in a lateral view. The guide member 13 is formed in a truncated chevron cross-sectional shape.

The upper end side in Figs. 2 and 3 indicates a mounting unit side end portion 21 disposed adjacent to the mounting portion of the lid, and the lower end side indicates a sublimation raw material-side end portion 23. In the mounting unit side end portion 21, a protrusion 25 extending upward (toward the lid 11) is integrally formed with a cover portion 27 extending toward the inner peripheral side (the center side in the diameter direction of the seed crystal 7).

The protrusion 25 is formed in a rectangular cross-sectional shape and a sidewall 31 of an inner peripheral side thereof is formed in the vertical direction. The cover portion 27 is formed in a triangular cross-sectional shape, the upper surface of the lid 11 side is formed on a cover surface 33, and an inner peripheral end edge of the cover portion 27 is indicated by reference numeral 29. Furthermore, the sidewall 31 and the cover surface 33 are formed by cutting out an inner peripheral side of the mounting unit side end portion 21.

As shown in Fig. 3, the cover portion 27 protrudes laterally toward the center in the diameter direction of the seed crystal 7 to cover an outer peripheral portion (a bevel portion 35) of the seed crystal 7, which is supported by the mounting portion 9, from the sublimation raw material 3 side which forms the lower side.

Meanwhile, Fig. 4 is a diagram corresponding to Fig. 3, which shows a conventional art, and the same reference numerals are used to designate the same elements as those of Fig. 3. A mounting unit side end portion 115 in a guide member 113 according to the conventional art is not provided with the cover portion 27 according to the embodiment.

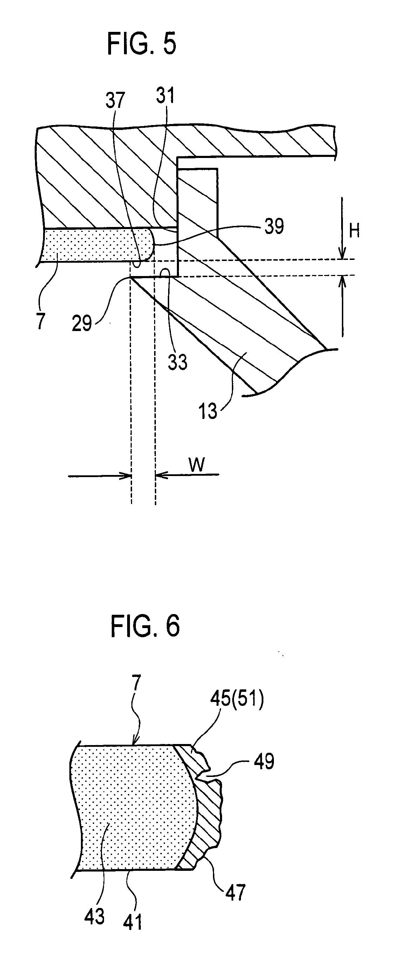

Fig. 5 is a cross-sectional view showing the dimension of the mounting unit side end portion in the guide member shown in Fig. 2. As shown in Fig. 5, H denotes a distance in the thickness direction of the seed crystal 7 between a growth surface 37 facing the sublimation raw material 3 in the outer peripheral portion (the bevel portion 35) of the seed crystal 7 and the cover surface 33 facing the seed crystal 7 in the cover portion 27 of the guide member 13. Furthermore, W denotes a distance in the diameter direction of the seed crystal 7 between an outer peripheral portion edge 39 of the seed crystal 7 and the inner peripheral end edge 29 in the cover portion 27 of the guide member 13. In such a case, the relationship between the distance H and the distance W is set such that H is smaller than W.

It is preferable that the distance H is as small as possible. Furthermore, it is preferable that the distance W is as large as possible. For example, when the distance H is 0 mm to 0.5 mm, it is preferable that the distance W is 0.5 mm to 2 mm. In addition, when the distance H is 0 mm to 0.1 mm, it is preferable that the distance W is 0.5 mm to 1 mm.

### (3) Description of generation principle of poor quality in growth crystal

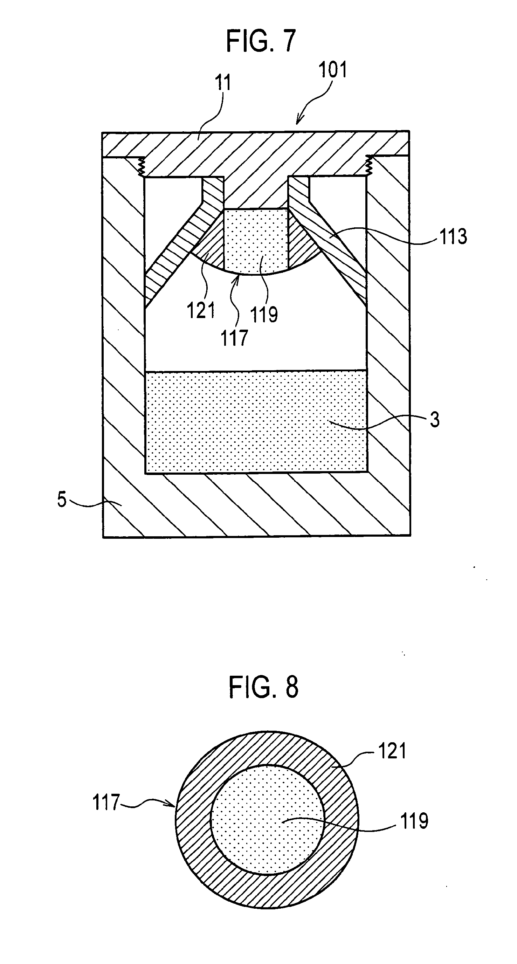

Next, the generation principle of the poor quality in a growth crystal will be described with reference to Figs. 6 to 8. Fig. 6 is an enlarged cross-sectional view of the bevel portion of the seed crystal. Fig. 7 is a cross-sectional view showing a state where a silicon carbide single crystal is grown using the conventional production apparatus. Fig. 8 is a schematic diagram when the growth crystal shown in Fig. 7 is viewed from the lower side thereof.

As shown in Fig. 6, since a lower surface (a surface of a sublimation raw material-side) serving as a growth surface 41 in the seed crystal 7 is generally polished by chemical machine polish (CMP) and the like, the lower surface is a planar surface with no concave-convex portion and the like. However, since an outer peripheral portion of a body 43 disposed at the center side in the diameter direction is called a bevel portion 45 and it is difficult to be polished by the chemical machine polish (CMP) and the like, it becomes a degenerated portion 51 having a concave-convex portion 47, particle shedding 49 and the like.

Here, in a crucible 101 according to the conventional production apparatus as shown in Fig. 7, the same reference numerals are used to designate the same elements as those of the crucible 1 shown in Fig. 1. A silicon carbide single crystal 117 grown using the crucible 101 shown in Fig. 7 includes a good quality portion 119 (hatched by dots) positioned at the center side in the diameter direction and a defective portion 121 (hatched by oblique lines) positioned at an outer peripheral side of the good quality portion 119. That is, a portion having the same diameter as that of the seed crystal 7 is the good quality portion 119 with no defective portions and an outer peripheral portion of the single crystal 117 grown from the bevel portion 35 is the defective portion 121.

### (4) Method for producing silicon carbide single crystal

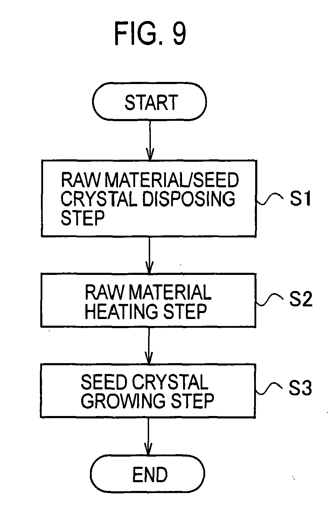

Next, the method for producing the silicon carbide single crystal will be briefly described. Fig. 9 is a flowchart showing the method for producing the silicon carbide single crystal according to the present invention.

As shown in Fig. 9, the method for producing the silicon carbide single crystal includes a raw material/seed crystal disposing step S1, a raw material heating step S2, and a seed crystal growing step S3.

In the raw material/seed crystal disposing step S1, the sublimation raw material 3 is disposed in the crucible body 5 and the seed crystal 7 is disposed at the mounting portion 9 of the lid 11.

Specifically, H denotes the distance between the growth surface 37 facing the sublimation raw material 3 in the outer peripheral portion (the bevel portion 35) of the seed crystal 7 and the cover surface 33 facing the seed crystal 7 in the cover portion 27 of the guide member 13, and W denotes the distance between an outer peripheral portion edge 39 of the seed crystal 7 and the inner peripheral end edge 29 in the cover portion 27 of the guide member 13. In such a case, the relationship between the distance H and the distance W is set such that H is smaller than W. For example, when the distance H is 0 mm to 0.5 mm, it is preferable that the distance W is 0.5 mm to 2 mm. In addition, when the distance H is 0 mm to 0.1 mm, it is preferable that the distance W is 0.5 mm to 1 mm.

In the raw material heating step S2, a current is applied to a heating coil (not shown) to heat the sublimation raw material 3, resulting in the generation of the sublimation gas G. In general, the heating temperature is 2000°C to 2500°C.

In the seed crystal growing step S3, in the state where the outer peripheral portion (the bevel portion 35) of the seed crystal 7, which faces the sublimation raw material 3, is covered by the cover portion 27 in the above-described guide member 13, the silicon carbide single crystal 117 is grown on the seed crystal 7. That is to say, in the state where H is set to be smaller than W, the silicon carbide single crystal 117 is grown on the seed crystal 7.

### (5) Comparison evaluation

Next, the present invention will be further clarified through an example.

According to the conventional art, as described in Figs. 6 to 8, the silicon carbide single crystal 117 is produced using the crucible 101 provided with the guide member 113 with no cover portion. Meanwhile, according to the example of the present invention, as described in Figs. 1 to 3, the silicon carbide single crystal is produced using the crucible 1 provided with the guide member 13 with a cover portion. In addition, producing conditions are as follows: atmosphere pressure is 10 kPa and temperature is 2200°C under an argon atmosphere.

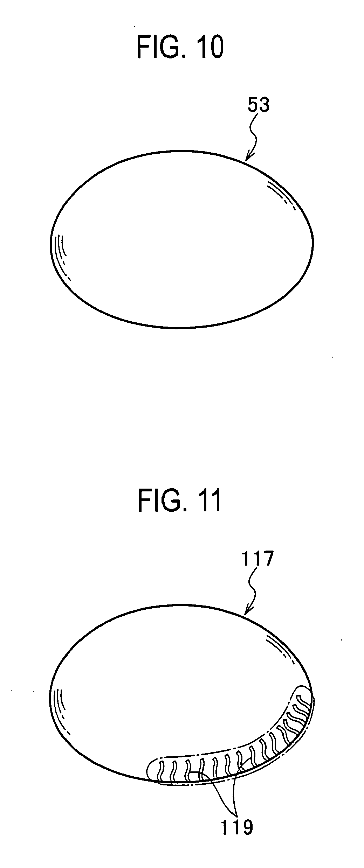

Figs. 9 and 10 are diagrams schematically showing a single crystal produced as described above. According to the example, a defectless, good single crystal 53 provided on the outer surface thereof is obtained as shown in Fig. 10. However, a single crystal 117 according to the conventional art is provided on the outer peripheral portion thereof with many degenerated portions 119 as indicated by a two-dot chain line of Fig. 11. In this way, when using the crucible 1 provided with the guide member 13 according to the present invention, it can be understood that a good single crystal can be obtained.

### (6) Advantages and effect

In general, in a sublimation recrystallization method, stress in the seed crystal is increased by lattice mismatch at the boundary between the seed crystal 7 and the degenerated portion 51 in the vicinity of the defective portion 121 of the single crystal grown from the bevel portion 35, causing defects such as micropipes or dislocation.

In order to reliably prevent the problems, in the apparatus for producing a silicon carbide single crystal according to the embodiment in which the seed crystal 7 including silicon carbide and the sublimation raw material 3 are held in the crucible 1 while facing each other, the seed crystal 7 and the sublimation raw material 3 are heated to generate the sublimation gas G, and the silicon carbide single crystal 53 is grown on the seed crystal 7, the crucible 1 includes the crucible body 5 configured to hold the sublimation raw material 3, the lid 11 provided with the mounting portion 9 configured to close an opening of the crucible body 5 and support the seed crystal 7, and the guide member 13 extending toward the sublimation raw material 3 from the outer peripheral portion of the mounting portion 9, and the cover portion 27 protrudes from the mounting unit side end portion 21 of the guide member 13, which faces the mounting portion 9, to cover the bevel portion 35 formed of the outer peripheral portion of the seed crystal 7 from the sublimation raw material 3 side.

As described above, since the guide member 13 according to the embodiment is provided with the cover portion 27 which covers the bevel portion 35 formed of the outer peripheral portion of the seed crystal 7, when a single crystal is grown, it is possible to suppress the growth of the single crystal from the bevel portion 35 formed of the outer peripheral portion of the seed crystal 7. Since the single crystal grown from the bevel portion 35 includes many defective portions 121, a good single crystal can be obtained by suppressing the growth of the single crystal from the bevel portion 35.

Furthermore, since the cover portion 27 of the guide member 13 is formed by cutting out the inner peripheral side of the mounting unit side end portion 21, the cover portion 27 can be easily produced.

In the embodiment, H is set to be smaller than W, where H denotes the distance in the thickness direction of the seed crystal 7 between the lower surface 41 serving as the growth surface facing the sublimation raw material 3 in the outer peripheral portion 35 of the seed crystal 7 and the cover surface 33 facing the seed crystal 7 in the cover portion 27 of the guide member 13, and W denotes the distance in the diameter direction of the seed crystal 7 between the outer peripheral portion edge 39 of the seed crystal 7 and the inner peripheral end edge 29 in the cover portion 27 of the guide member 13. Consequently, it is possible to surely prevent a case where the inside of the single crystal 117 is affected by the defective portion 121 (the degenerated portion 51) grown from the bevel portion 35.

In the embodiment, it is preferable that the distance H is as small as possible. Furthermore, it is preferable that the distance W is as large as possible. For example, when the distance H is 0 mm to 0.5 mm, it is preferable that the distance W is 0.5 mm to 2 mm. In addition, if the distance W is smaller than 0.5 mm, it may be difficult to prevent the influence of the defective portion 121 (the degenerated portion 51) grown from the bevel portion 35. Meanwhile, if the distance W is larger than 2 mm, it may not be possible to obtain a desired diameter of the single crystal.

### (7) Other embodiments of the present invention

In addition, it should be understood that those descriptions and drawings constituting a part of the present disclosure according to the embodiment do not limit the present invention. From the present disclosure, various alternative embodiments, examples and operational technologies will become apparent to those skilled in the art.

For example, in the embodiment, the cover portion of the guide member is formed in a triangular cross-sectional shape. However, the present invention is not limited thereto. The cover portion may protrude toward the center in the diameter direction of the seed crystal and may be formed in a rectangular cross-sectional shape.

Thus, needless to say, the present invention includes a variety of embodiments not described here. Therefore, the technical scope of the present invention is only defined by the invention specific matters according to the claims reasonably derived from the above description.

## Claims

1. An apparatus for producing a silicon carbide single crystal, which is configured to hold a seed crystal including silicon carbide and a sublimation raw material (3) in a crucible (1) while facing each other, configured to generate sublimation gas (G) by heating the seed crystal and the sublimation raw material, and grow the silicon carbide single crystal on the seed crystal, wherein
the crucible comprises:
a crucible body (5) configured to hold the sublimation raw material;
a lid (11) configured to close an opening of the crucible body and provided with a mounting portion (9) configured to support the seed crystal; and
a guide member (13) extending toward a sublimation raw material side from an outer peripheral portion of the mounting portion, wherein
the guide member has a cover portion (27) configured to cover an outer peripheral portion of the seed crystal from the sublimation raw material side, the cover being protruded from a mounting unit side end portion (21) provided on a mounting portion side.

2. An apparatus for producing a silicon carbide single crystal according to claim 1, wherein the cover portion is formed by cutting out an inner peripheral side of the mounting unit side end portion.

3. A method for producing a silicon carbide single crystal by holding a seed crystal including silicon carbide and a sublimation raw material in a crucible while facing each other, generating sublimation gas by heating the seed crystal and the sublimation raw material, and growing the silicon carbide single crystal on the seed crystal, the method comprising the steps of:
(A) heating the sublimation raw material to generate the sublimation gas in a crucible including a crucible body configured to hold the sublimation raw material, a lid provided with a mounting portion configured to close an opening of the crucible body and configured to support the seed crystal, and a guide member extending toward the sublimation raw material from an outer peripheral portion of the mounting portion (S2); and
(B) growing the silicon carbide single crystal on the seed crystal in a state where a cover portion covers an outer peripheral portion of the seed crystal from a sublimation raw material side, the cover being protruded from a mounting portion side end portion provided on a mounting portion side (S3).

4. A method for producing a silicon carbide single crystal according to claim 3, further comprising a step of (C) causing H to be smaller than W (S1), where H denotes a distance in a thickness direction of the seed crystal between a growth surface facing the sublimation raw material in an outer peripheral portion of the seed crystal and a cover surface facing the seed crystal in the cover portion, and W denotes a distance in a diameter direction of the seed crystal between an outer peripheral portion edge of the seed crystal and an inner peripheral end edge in the cover portion.

5. A method for producing a silicon carbide single crystal according to claim 4, wherein the distance H is 0 mm to 0.5 mm and the distance W is 0.5 mm to 2 mm.
